# EUROPEAN PATENT APPLICATION

(11) **EP 4 471 176 A1**
(43) Date of publication of application: **04.12.2024**
(21) Application number: 22921634.6
(22) Date of filing: 24.11.2022
(51) Int. Cl.: C23C 16/455

(54) **FURNACE TUBE FOR THIN FILM DEPOSITION, THIN FILM DEPOSITION METHOD AND PROCESSING APPARATUS**

(30) Priority: 24.01.2022 CN 202210081260
(71) Applicant: ACM Research (Shanghai) Inc., Shanghai 201203 (CN); ACM Research (Lingang), Inc., Shanghai 201303 (CN); ACM Research Korea Co., Ltd., Icheon-si, Gyeonggi-do (KR); Cleanchip Technologies Limited, Hong Kong (HK)
(72) Inventor: WANG, Hui, Shanghai 201203 (CN); ZHANG, Shan, Shanghai 201203 (CN); ZHOU, Dongcheng, Shanghai 201203 (CN); SHEN, Hui, Shanghai 201203 (CN); LV, Ce, Shanghai 201203 (CN); PARK, Daniel, Icheon-si, Gyeonggi-do (KR); KIM, John, Icheon-si, Gyeonggi-do (KR); ZHANG, Dahai, Shanghai 201203 (CN); ZHANG, Xiaoyan, Shanghai 201203 (CN); WANG, Jun, Shanghai 201203 (CN); JIA, Shena, Shanghai 201203 (CN); WANG, Jian, Shanghai 201203 (CN)
(74) Representative: Osha BWB
(86) International application number: PCT/CN2022/134122
(87) International publication number: WO 2023/138210

(57) **Abstract**

The present invention discloses a furnace tube for thin film deposition, comprising: a process tube; a wafer boat, arranged inside the process tube and provided with multi-layered supporting members along the length direction of the process tube; a gas supply tube, arranged inside the process tube and provided with multi-layered gas supply holes along the length direction of the process tube. Multi-layered exhaust holes are arranged on the sidewall of the process tube along the length direction, wherein the distribution area of the gas supply holes is gradually reduced from top to bottom along the length direction of the sidewall of the process tube, and the distribution area of the exhaust holes is gradually reduced from top to bottom along the length direction of the sidewall of the process tube. The present invention makes the distribution area of the gas supply holes gradually reduced from top to bottom along the length direction of the sidewall of the process tube and the distribution area of the exhaust holes gradually reduced from top to bottom along the length direction of the sidewall of the process tube by providing multi-layered gas supply holes and multi-layered exhaust holes, so that the gas supply amount of gas supply holes of each layer is the same, and the gas exhaust amount of exhaust holes of each layer is the same, thereby ensuring the uniformity of the thin film deposited on the substrate of each layer consistent.

## Description

### BACKGROUND OF THE INVENTION

### Field of the Invention

The present invention relates to the field of semiconductor manufacturing, in particular to a furnace tube for thin film deposition, thin film deposition methods and a processing apparatus.

### The Related Art

With the decrease of semiconductor device size, the technology of thin film deposition on larger substrate area is increasingly required. Deposition of semiconductor thin films with more uniform composition and thickness is incredibly important for the manufacture of high-quality semiconductor devices. At present, furnace tube chemical vapor deposition (CVD) and furnace tube atomic layer deposition (ALD) methods to prepare semiconductor thin films occupy a huge market share.

In the traditional furnace tube low pressure chemical vapor deposition (LPCVD) process, two or more volatile gaseous precursors react and/or decompose on the substrate surface to a thin film that needs to be deposited. However, the traditional furnace tube deposition process is related to various factors such as gas flow distribution, substrate temperature, substrate pressure, and gas flow rate. Once these factors deviate during the process, there will be some quality deviations in the deposited films, which will lead to the failure of the device.

At present, vertical furnace tube atomic layer deposition (ALD) also has the defects of uneven gas injection in the gas supply tube, and the design of the process tube inside the furnace tube easily leads to the defects that the gas precursor cannot be uniformly distributed on the substrate surface. In order to achieve the uniform distribution of the gas precursor on the substrate surface, it is particularly important to improve the design of the gas supply tube and process tube of vertical furnace tube.

In conclusion, it is necessary to propose a new design of furnace tube to solve the above problem.

### SUMMARY

In view of the disadvantages of the prior art described above, the present invention aims to provide a furnace tube for thin film deposition, which is used to solve the problem of uneven distribution of process gas on the surface of a substrate in a vertical furnace tube in the prior art.

To achieve the above and other related objectives, the present invention provides a furnace tube for thin film deposition, comprising:
a process tube;
a wafer boat, arranged inside the process tube and provided with multi-layered supporting members along the length direction of the process tube to support multi-layered substrates;
a gas supply tube, arranged inside the process tube and provided with multi-layered gas supply holes along the length direction of the process tube, the gas supply holes of each layer corresponding to the substrate of each layer one by one to supply process gas to the substrate of each layer;
multi-layered exhaust holes arranged on the sidewall of the process tube along the length direction of the sidewall of the process tube, the exhaust holes of each layer corresponding to the substrate of each layer one by one;
wherein, the distribution area of the gas supply holes on the gas supply tube is gradually reduced from top to bottom along the length direction of the sidewall of the process tube, and the distribution area of the exhaust holes on the sidewall of the process tube is gradually reduced from top to bottom along the length direction of the sidewall of the process tube, so that the gas supply amount of gas supply holes of each layer is the same, and the gas exhaust amount of exhaust holes of each layer is the same.

In one embodiment of the present invention, the exhaust hole of each layer is a slit hole, the exhaust hole of each layer is arranged opposite the gas supply holes of each layer, the height of the slit hole of each layer is the same, and the length of the slit hole of each layer is gradually reduced from top to bottom along the length direction of the sidewall of the process tube.

In one embodiment of the present invention, wherein exhaust holes of each layer are multiple small holes, exhaust holes of each layer are arranged opposite the gas supply holes of each layer.

In one embodiment of the present invention, wherein exhaust holes of each layer are multiple slit holes, and the multiple slit holes of each layer are located on a circle of the sidewall of the process tube.

In one embodiment of the present invention, wherein exhaust holes of each layer are of the same size, and the number of exhaust holes of each layer decreases gradually from top to bottom along the length direction of the sidewall of the process tube.

In one embodiment of the present invention, wherein exhaust holes of each layer are of the same number, and the size of exhaust holes of each layer is gradually reduced from top to bottom along the length direction of the sidewall of the process tube.

In one embodiment of the present invention, wherein the length of multiple slit holes located on a circle of the sidewall of the process tube gradually increases in the direction from near to away from the gas supply holes.

In one embodiment of the present invention, wherein the size of the slit holes of each layer is gradually reduced from top to bottom along the length direction of the sidewall of the process tube.

In one embodiment of the present invention, comprising multiple sets of the gas supply tubes, uniformly distributed along the circumference of the process tube.

In one embodiment of the present invention, wherein the gas supply holes of each layer are a plurality of small holes, the gas supply holes of each layer are of the same size, and the number of gas supply holes of each layer is gradually reduced from top to bottom along the length direction of the gas supply tube.

In one embodiment of the present invention, wherein the gas supply holes of each layer are a plurality of small holes, the number of gas supply holes of each layer is the same, and the size of the gas supply holes of each layer is gradually reduced from top to bottom along the length direction of the gas supply tube.

In one embodiment of the present invention, wherein the gas supply hole of each layer is a slit hole, and the length of the gas supply hole of each layer is gradually reduced from top to bottom along the length direction of the gas supply tube.

In one embodiment of the present invention, wherein at least one first pumping port is arranged in the inside of the process tube.

In one embodiment of the present invention, wherein at least one second pumping port is arranged at the outside of the process tube.

In one embodiment of the present invention, wherein at least one pair of radio-frequency electrodes is arranged on the inside or outside of the process tube, and at least one pair of radio-frequency electrodes are sleeved with two insulating sleeves respectively.

In one embodiment of the present invention, further comprising:
a liner tube, sleeved on the outside of the process tube;
a heating assembly, sleeved on the outside of the liner tube, for heating the liner tube.

In one embodiment of the present invention, wherein at least one pair of radio-frequency electrodes is arranged on the outside of the liner tube.

The present invention further provides a method for thin film deposition using furnace tube based on chemical vapor deposition (CVD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying process gas to the substrate of each layer from bottom to top along the length direction of the process tube through the multi-layered gas supply holes, wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the process gas is deposited to form a thin film on the surface of substrate of each layer;
Step 3: multi-layered exhaust holes are arranged on the sidewall of the process tube, and excess process gas is exhausted through the multi-layered exhaust holes, wherein the distribution area of the exhaust holes on the sidewall of the process tube is arranged to gradually decrease from top to bottom along the length direction of the sidewall of the process tube, so that the exhaust amount of substrate of each layer is the same, and the excess gas is pumped out by a gas pump.

The present invention further provides a method for thin film deposition using furnace tube based on chemical vapor deposition (CVD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying process gas to the substrate of each layer from bottom to top along the length direction of the process tube through the multi-layered gas supply holes, wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the process gas is dissociated into plasma by radio-frequency electrode, and the plasma is deposited to form a thin film on the surface of substrate of each layer;
Step 3: multi-layered exhaust holes are arranged on the sidewall of the process tube, and excess process gas is exhausted through the multi-layered exhaust holes, wherein the distribution area of the exhaust holes on the sidewall of the process tube is arranged to gradually decrease from top to bottom along the length direction of the sidewall of the process tube, so that the exhaust amount of the substrate of each layer is the same, and the excess gas is pumped out by a gas pump.

The present invention further provides a method for thin film deposition using furnace tube based on atomic layer deposition (ALD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying the first process gas to the substrate of each layer from bottom to top along the length direction of the process tube through the multi-layered gas supply holes , wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the first process gas is adsorbed on the surface of substrate of each layer, and multi-layered exhaust holes are arranged on the sidewall of the process tube, wherein the distribution area of the exhaust holes on the sidewall of the process tube is arranged to gradually decrease from top to bottom along the length direction of the sidewall of the process tube, and the excess first process gas is exhausted through the multi-layered exhaust holes, so that the exhaust amount of the substrate of each layer is the same, and the excess first process gas is pumped out through a gas pump;
Step 3: supplying purge gas through the gas supply tube to purge the interior of the process tube;
Step 4: the second process gas is supplied to the substrate of each layer from bottom to top along the length direction of the process tube through the multi-layered gas supply holes, so that the gas supply amount to substrate of each layer inside the process tube is the same;
Step 5: the second process gas reacts with the first process gas adsorbed on the surface of substrate of each layer to form a film on the surface of substrate of each layer, and the excess second process gas is exhausted through the exhaust holes of each layer, so that the exhaust amount of the substrate of each layer is the same, and the excess second process gas is pumped out by a gas pump;
Step 6: supplying purge gas through the gas supply tube to purge the interior of the process tube;
Step 7: repeating steps 1 to 6 above until the film deposited on the surface of substrate of each layer reaches a certain thickness.

The present invention further provides a method for thin film deposition using furnace tube based on atomic layer deposition (ALD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying the first process gas to the substrate of each layer from bottom to top along the length direction of the process tube through the multi-layered gas supply holes , wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the first process gas is adsorbed on the surface of substrate of each layer, and multi-layered exhaust holes are arranged on the sidewall of the process tube, wherein the distribution area of the exhaust holes on the sidewall of the process tube is arranged to gradually decrease from top to bottom along the length direction of the sidewall of the process tube, and the excess first process gas is exhausted through the multi-layered exhaust holes, so that the exhaust amount of the substrate of each layer inside the process tube is the same, and the excess first process gas is pumped out through a gas pump;
Step 3: supplying purge gas through the gas supply tube to purge the interior of the process tube;
Step 4: the second process gas is dissociated into a second plasma under the action of the radio-frequency electrode, and the second plasma is supplied to the substrate of each layer from bottom to top along the length direction of the process tube through the multi-layered gas supply holes, so that the gas supply amount to substrate of each layer inside the process tube is the same;
Step 5: the second plasma reacts with the first process gas adsorbed on the surface of substrate of each layer to form a film on the surface of substrate of each layer, and the excess second plasma is exhausted through the exhaust holes of each layer, so that the exhaust amount of the substrate of each layer is the same, and the excess second plasma is pumped out by a gas pump;
Step 6: supplying purge gas through the gas supply tube to purge the interior of the process tube;
Step 7: repeating steps 1 to 6 above until the film deposited on the surface of substrate of each layer reaches a certain thickness.

In one embodiment of the present invention, wherein turn on the radio-frequency power supply when a first process gas is supplied in step 1, and the first process gas is dissociated into a first plasma under the action of the radio-frequency electrode before the first process gas is supplied to the gas supply tube, and the first plasma is supplied to substrate of each layer from bottom to top along the length direction of the process tube through multi-layered gas supply holes, so that the supply amount of substrate of each layer inside the process tube is the same.

The present invention further provides a processing apparatus, comprising:
a holding device, for holding a part to be processed;
a perforating device, arranged on the top of the holding device, for perforating the part;
a controlling device, electrically connected to the perforating device, wherein the perforating device is capable of moving along the length direction of the part under the action of the controlling device, wherein the controlling device is configured to make the distribution area of the holes on the part gradually decrease from top to bottom along the length direction of the sidewall of the part by controlling the perforating position and/or the perforating size of the perforating device;
a driving device, connected with the holding device, for driving the part to rotate.

In one embodiment of the present invention, further comprising a clamping structure, detachably arranged at both ends of the holding device, for clamping the parts to be processed.

The present invention further provides a gas supply tube of a furnace tube for thin film deposition, wherein the gas supply tube is provided with multi-layered gas supply holes along the length direction, and the distribution area of the multi-layered gas supply holes is gradually reduced from top to bottom along the length direction of the sidewall of the gas supply tube, so that when the gas is supplied from bottom to top, the gas supply amount of gas supply holes of each layer is the same.

The present invention further provides a process tube of a furnace tube for thin film deposition, wherein the sidewall of the process tube is provided with multi-layered exhaust holes along the length direction, and the distribution area of the multi-layered exhaust holes is gradually reduced from top to bottom along the length direction of the sidewall of the process tube, so that the exhaust amount of exhaust holes of each layer is the same.

In one embodiment of the present invention, wherein the exhaust hole of each layer is a slit hole, the slit hole of each layer has the same height, and the length of the slit hole of each layer gradually decreases from top to bottom along the length direction of the sidewall of the process tube.

In one embodiment of the present invention, wherein exhaust holes of each layer are a plurality of small holes, the exhaust holes of each layer are of the same size, and the number of the exhaust holes of each layer is gradually reduced from top to bottom along the length direction of the sidewall of the process tube.

In one embodiment of the present invention, wherein exhaust holes of each layer are a plurality of small holes, the number of exhaust holes of each layer is the same, and the size of exhaust holes of each layer is gradually reduced from top to bottom along the length direction of the sidewall of the process tube.

In one embodiment of the present invention, wherein exhaust holes of each layer are a plurality of slit holes, and the plurality of slit holes of each layer are located on a circle of the sidewall of the process tube.

In one embodiment of the present invention, wherein the size of exhaust holes of each layer is the same, and the number of exhaust holes of each layer gradually decreases from top to bottom along the length direction of the sidewall of the process tube; or the number of exhaust holes of each layer is the same, and the size of exhaust holes of each layer is gradually reduced from top to bottom along the length direction of the sidewall of the process tube.

In one embodiment of the present invention, wherein the plurality of slit holes located on a circle of the sidewall of the process tube are of different sizes.

In one embodiment of the present invention, wherein the size of slit holes of each layer gradually decreases from top to bottom along the length direction of the sidewall of the process tube.

As described above, compared with the prior art, the furnace tube for thin film deposition provided by the present invention has the following beneficial effects:

In the furnace tube for film deposition provided by the invention, multi-layered gas supply holes are arranged on the gas supply tube, and multi-layered exhaust holes are arranged on the sidewall of the process tube. The distribution area of the gas supply holes is gradually reduced from top to bottom along the length direction of the sidewall of the process tube, and the distribution area of the exhaust holes is gradually reduced from top to bottom along the length direction of the sidewall of the process tube, thereby realizing the same gas supply amount of gas supply holes of each layer inside the process tube and the same exhaust amount of exhaust holes of each layer, ensuring the uniformity of the thin film deposited on the substrate of each layer inside the process tube.

### BRIEF DESCRIPTION OF THE DRAWINGS

Fig. 1 shows a schematic diagram of a furnace tube provided by the first embodiment of the present invention.
Figs. 2A and 2B respectively show top views at the AA' position and the BB' position of the furnace tube structure of Fig. 1 provided by the first embodiment without radio-frequency electrodes.
Figs. 3A and 3B respectively show top views at the AA' position and the BB' position of the furnace tube structure of Fig. 1 provided by the first embodiment with radio-frequency electrodes added to the inside of the process tube.
Figs. 4A and 4B respectively show top views at the AA' position and the BB' position of the furnace tube structure of Fig. 1 provided by the first embodiment with radio-frequency electrodes added to the outside of the process tube.
Figs. 5A and 5B respectively show top views at the AA' position and the BB' position of the furnace tube structure of Fig. 1 provided by the first embodiment with radio-frequency electrodes added to the outside of the liner tube.
Fig. 6A shows a schematic diagram of a multi-layered gas supply holes on the gas supply tube provided by the first embodiment of the present invention.
Fig. 6B shows a schematic diagram of various shapes of gas supply holes provided by the present invention.
Fig. 6C shows a schematic diagram of a multi-layered gas supply holes on the gas supply tube provided by another embodiment of the present invention.
Fig. 7 shows a schematic diagram of a furnace tube provided by the second embodiment of the present invention.
Fig. 8 shows a schematic diagram of a furnace tube provided by the third embodiment of the present invention.
Fig. 9A shows a schematic diagram of a furnace tube provided by the fourth embodiment of the present invention.
Fig. 9B shows a top view at the CC' position in Fig. 9A provided by the fourth embodiment of the present invention.
Figs. 10A, 10B, and 10C respectively show top views of several sets of gas supply tubes provided by the present invention.
Fig. 11 shows a logic schematic diagram of a supply gas switch provided by the eighth embodiment of the present invention.
Fig. 12 shows a schematic diagram of a processing apparatus provided by the ninth embodiment of the present invention.

### DETAILED DESCRIPTION OF EMBODIMENTS

The following describes the embodiments of the present invention through specific examples, those skilled in the art can easily understand other advantages and effects of the present invention from the content disclosed in this specification. The present invention can also be implemented or applied by other different specific embodiments, and the details in the present specification can also be modified or changed based on different views and applications without departing from the spirit of the present invention.

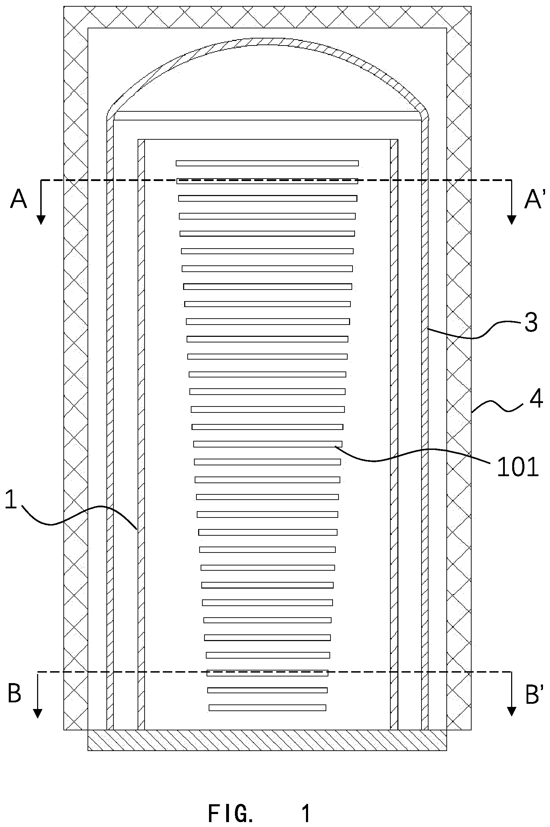

Please refer to Fig. 1 to Fig. 12. It should be noted that the diagrams provided in this embodiment only illustrate the basic concept of the present invention in a schematic manner. Although only components related to the present invention are displayed in the diagrams instead of being drawn according to the number, shape and size of components in actual implementation, the shape, number and proportion of each component in actual implementation can be changed at will, and the layout of the components can also be more complicated.

### First embodiment

The present invention provides a furnace tube for thin film deposition, as shown in Figs. 1, 2A and 6A, specifically, the furnace tube comprises a process tube 1, a wafer boat, a gas supply tube 2, a liner tube 3, and a heating assembly 4. The wafer boat is arranged inside the process tube 1 with multi-layered supporting members along the length direction of the process tube 1 for supporting multi-layered substrates (not shown in the accompanying drawings). The gas supply tube 2 is arranged inside the process tube 1, and the gas supply tube 2 is provided with multi-layered gas supply holes 201 along the length direction of the process tube 1, and gas supply holes of each layer 201 corresponds to substrate of each layer one-to-one to supply process gas to substrate of each layer. The furnace tube can include one or more gas supply tubes 2, and a corresponding number of gas supply tubes 2 is provided according to process requirements. For example, when the SiON film is grown, three kinds of process gases are used, accordingly, the number of gas supply tubes 2 is three, and each process gas corresponds to one gas supply tube. When SiN film is grown, two kinds of process gases are used, accordingly, the number of gas supply tubes 2 is two. The sidewall of the process tube 1 is provided with a plurality of layers of exhaust holes 101 along the length direction thereof, and the exhaust holes of each layer 101 corresponds one by one to substrate of each layer. The distribution area of the gas supply holes 201 gradually decreases from top to bottom along the length direction of the sidewall of the process tube 1, and the distribution area of the exhaust holes 101 gradually decreases from top to bottom along the length direction of the sidewall of the process tube 1. Herein, the distribution area of the gas supply holes 201 is the sum of the areas of one or more gas supply holes 201. At each position along the length direction of the gas supply tube 2, the distribution area of the gas supply holes 201 is the sum of the areas of one or more gas supply holes 201 in the circumferential direction of the gas supply tube 2 at that position. Similarly, the distribution area of the exhaust holes 101 is the sum of the areas of one or more exhaust holes 101. At each position along the length direction of the sidewall of the process tube 1, the distribution area of the exhaust holes 101 is the sum of the areas of one or more exhaust holes 101 in the circumferential direction of the process tube 1 at that position. By this design, the gas supply amount of the gas supply holes of each layer 201 is the same, and the gas displacement amount of each layer of the gas exhaust holes 101 is the same, so that the gas on the substrate of each layer is uniformly distributed, thereby achieving uniformity of the deposited film on the substrate of each layer. The liner tube 3 is sleeved on the outside of the process tube 1. The heating assembly 4 is arranged outside the liner tube 3 to heat the liner tube 3.

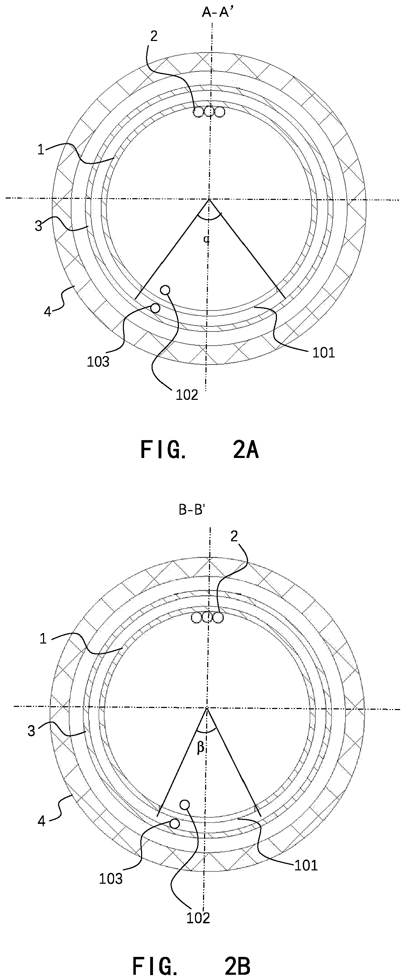

In the first embodiment, as shown in Fig. 1, the exhaust holes of each layer 101 is a slit hole, the height of the slit holes of each layer 101 is the same, and the length of the slit holes of each layer 101 gradually decreases from top to bottom along the length direction of the sidewall of the process tube 1. As shown in Fig. 2A, exhaust holes of each layer 101 is disposed opposite gas supply holes of each layer 201. As can be seen from the top views in the AA' direction and the BB' direction shown in Figs. 2A and 2B, the length of the slit holes of each layer 101 gradually decreases from top to bottom along the length direction of the sidewall of the process tube 1, and the opening angle α of the slit hole 101 at the upper position AA' of the process tube 1 is larger than the opening angle β of the slit hole 101 at the lower position BB' of the process tube 1. As a result, the distribution area of the exhaust holes 101 is gradually reduced from top to bottom along the length direction of the sidewall of the process tube 1. By exhausting the gas in a manner that the exhausting amount of substrate of each layer is uniform, the exhausting amount of substrate of each layer inside the process tube 1 is the same.

As shown in Figs. 2A and 2B, at least one first pumping port 102 is provided in the inside of the process tube 1. When the film deposition process is carried out by atomic layer deposition (ALD), after the excess process gas is pumped out by the gas pump, it is necessary to pass the purge gas to purge the interior of the process tube 1. At this time, the gas pump connected to the first pumping port 102 can be opened, and the purge gas can be quickly extracted through the first pumping port 102, so as to improve the process efficiency. A plurality of first pumping ports 102 can be provided, and the plurality of first pumping ports 102 are uniformly distributed along the inner circumferential of the process tube 1.

At least one second pumping port 103 is provided at the outside of the process tube 1. A plurality of second pumping ports 103 can be provided, and the plurality of second pumping ports 103 are uniformly distributed along the outer circumference of the process tube 1. When a film deposition process is performed by chemical vapor deposition (CVD) and atomic layer deposition (ALD), the excess process gas inside the process tube 1 is pumped out by gas pump through the second pumping port 103. Thus, when the film deposition process is performed by chemical vapor deposition (CVD), it is capable to only provide the second pumping port 103, and the first pumping port 102 can be omitted. When the thin film deposition process is performed by atomic layer deposition (ALD), it is capable to only provide the second pumping port 103. Preferably, the first pumping port 102 can be further provided in order to improve the process efficiency.

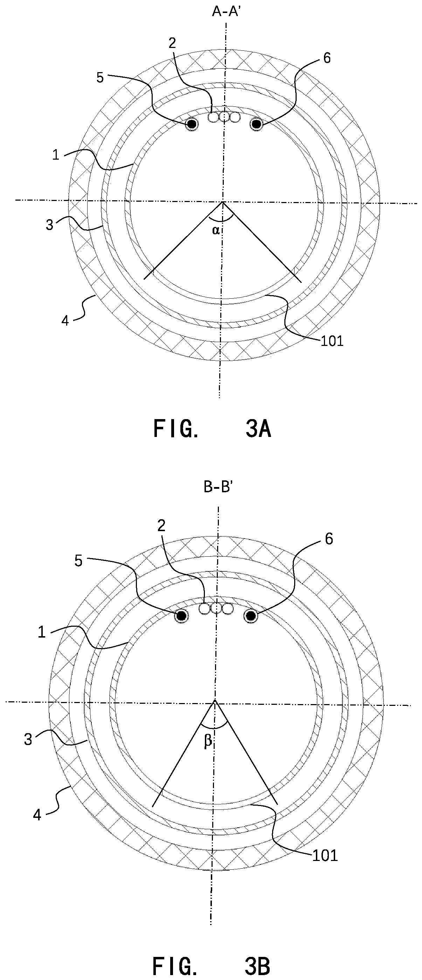

In other embodiments of the present invention, as shown in Figs. 3A and 3B, a pair of radio-frequency electrodes 5 are provided on the inside of the process tube 1, and two insulating sleeves 6 are sleeved on the outside of the pair of radio-frequency electrodes 5 respectively. Among them, the material of the insulating sleeves 6 can be any one of quartz, silicon, alumina or other ceramics or silicon carbide. The frequency of the RF electrodes can be 10-30MHZ, the rated power is 0.5-5KW, and the applied power is 0.1-3KW.

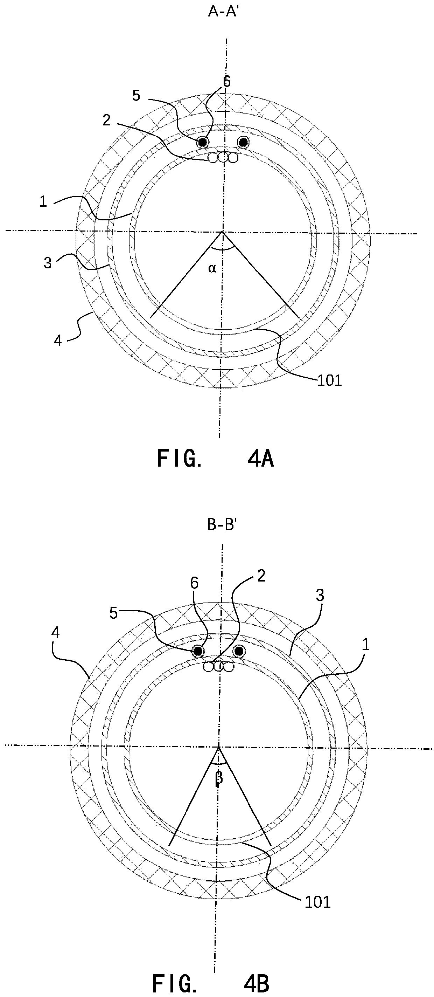

In another embodiment of the present invention, as shown in Figs. 4A and 4B, a pair of radio-frequency electrodes 5 are provided on the outside of the process tube 1, and two insulating sleeves 6 are sleeved on the outside of the pair of radio-frequency electrodes 5 respectively. The material of the insulating sleeves 6 can be any one of quartz, silicon, alumina, other ceramics, or silicon carbide.

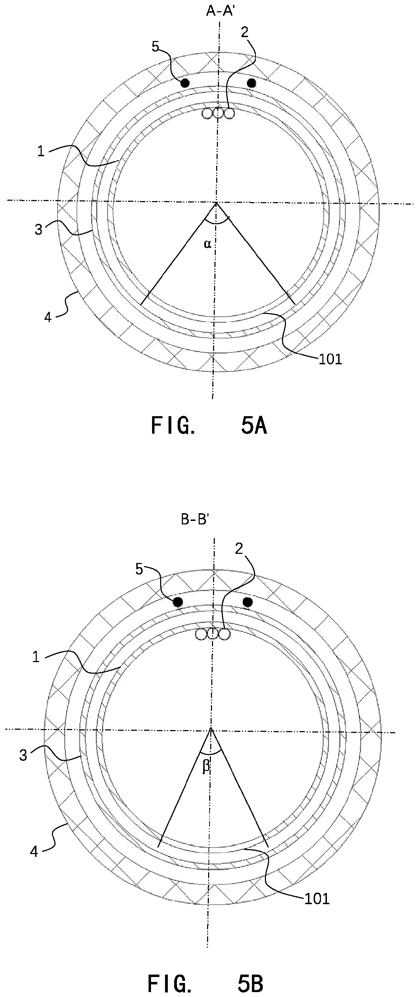

In another embodiment of the present invention, as shown in Figs. 5A and 5B, a pair of radio-frequency electrodes 5 are provided on the outside of the liner tube 3.

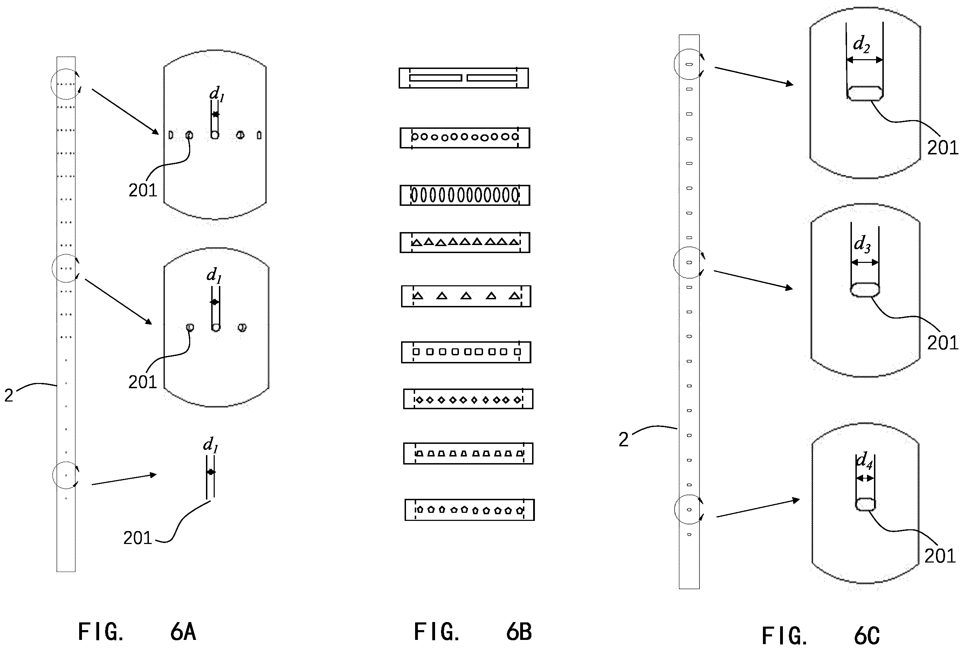

In the first embodiment, as shown in Fig. 6A, the gas supply holes of each layer 201 in the gas supply tube 2 is a plurality of small holes, the size of the small holes of each layer 201 is the same. The size of each small hole is *d*₁, and the number of small holes of each layer 201 gradually decreases from top to bottom along the length direction of the gas supply tube 2. As a result, the distribution area of the gas supply holes 201 is gradually reduced from top to bottom along the length direction of the sidewall of the gas supply tube 2. Since the supply gas is supplied from bottom to top, the gas flow rate below the gas supply tube 2 is larger than the gas flow rate above the gas supply tube 2, resulting in uneven gas supply to the substrate of each layer. Therefore, the number of small holes of the gas supply holes of each layer 201 is gradually reduced from top to bottom along the length direction of the gas supply tube 2, so that the amount of gas supplied to the substrate of each layer is equal.

In other embodiments of the present invention, the gas supply holes of each layer 201 is a plurality of small holes, the number of small holes of the gas supply holes of each layer 201 is the same, and the size of small holes of the gas supply holes of each layer 201 is gradually reduced from top to bottom along the length direction of the gas supply tube 2, so that the amount of gas supplied to the substrate of each layer is equal.

As shown in Fig. 6B, the shape of the plurality of small holes of the gas supply holes of each layer 201 can be any one of square holes, circular holes, elliptical holes, triangular holes, quadrilateral holes, trapezoidal holes, pentagonal holes, polygonal holes, and the like.

In another embodiment of the present invention, as shown in Fig. 6C, the gas supply holes of each layer 201 is a slit hole, and the length of the slit hole 201 of each layer gradually decreases from top to bottom along the length direction of the gas supply tube 2. Wherein, the length of the slit hole 201 located on the upper end of the gas supply tube 2 is *d*₂, the length of the slit hole 201 in the middle of the gas supply tube 2 is *d*₃, and the length of the slit hole 201 located on the lower end of the gas supply tube 2 is *d*₄, and *d*₂ > *d*₃ >₄, so that the amount of gas supplied to the substrate of each layer is equal.

In summary, the gas supply tube 2 supplies gas to substrate of each layer from bottom to top along the length direction of the process tube 1 in a manner that the gas is supplied in a uniform amount, so that the gas supply amount to substrate of each layer inside the process tube 1 is the same.

### Second embodiment

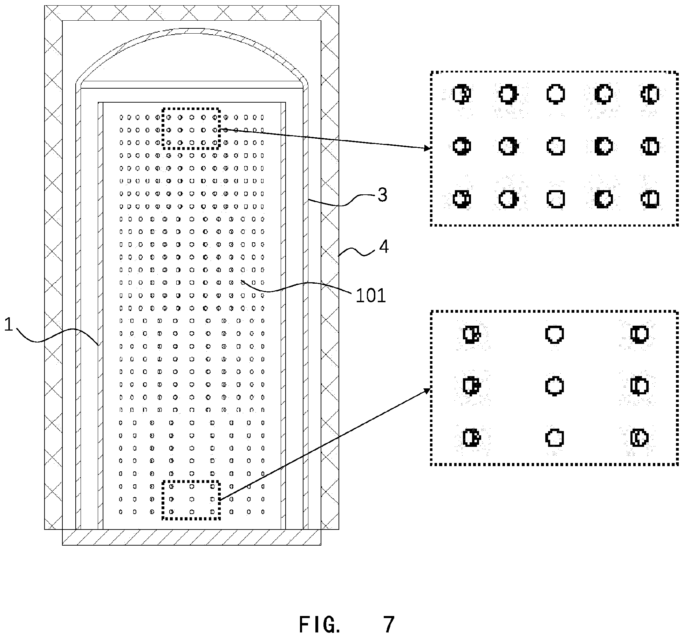

As shown in Fig. 7, the second embodiment provides a furnace tube for thin film deposition, distinguished from the first embodiment in that:
The exhaust holes of each layer 101 are a plurality of small holes, and the exhaust holes of each layer 101 are disposed opposite gas supply holes of each layer 201. As shown in Fig. 7, the size of the small holes of the exhaust holes of each layer 101 is the same, and the number of small holes of the exhaust holes of each layer 101 gradually decreases from top to bottom along the length direction of the sidewall of the process tube 1. As a result, the distribution area of the exhaust holes 101 is gradually reduced from top to bottom along the length direction of the sidewall of the process tube 1. That is, the size of the small holes of the exhaust holes of each layer 101 is the same, and the density of the small holes of the exhaust holes of each layer 101 located on the upper sidewall of the process tube 1 is greater than that of the small holes of the exhaust holes of each layer 101 located on the lower sidewall of the process tube 1. In the present embodiment, the purpose is also to exhaust the gas by using an exhaust method that the gas amount exhausted from the substrate of each layer is uniform, so that the exhaust amount of the substrate of each layer inside the process tube 1 is the same.

Other settings of this embodiment are the same as those of the first embodiment and will not be repeated here.

### Third embodiment

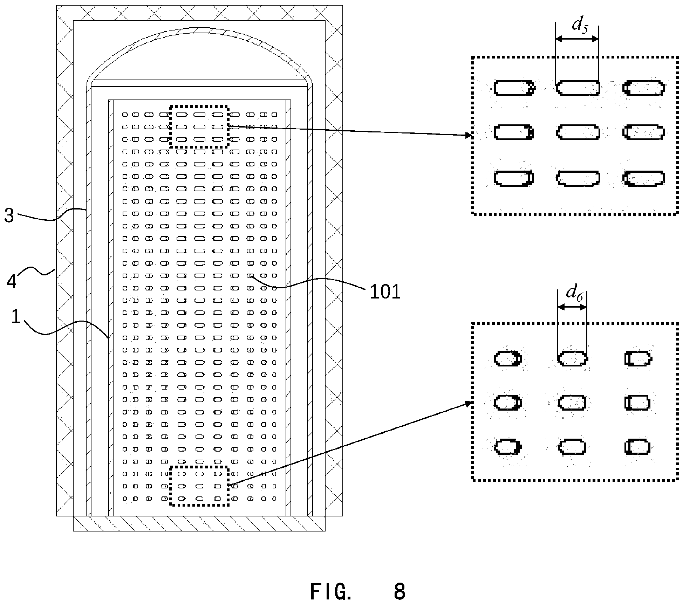

As shown in Fig. 8, the third embodiment provides a furnace tube for thin film deposition, distinguished from the first embodiment in that:
The exhaust holes of each layer 101 are a plurality of small holes, and the exhaust holes of each layer 101 are disposed opposite gas supply holes of each layer 201. As shown in Fig. 8, the number of the small holes of the exhaust holes of each layer 101 is the same, and the size of the small holes of the exhaust holes of each layer 101 gradually decreases from top to bottom along the length direction of the sidewall of the process tube 1. As a result, the distribution area of the exhaust holes 101 is gradually reduced from top to bottom along the length direction of the sidewall of the process tube 1. Wherein, the size *d*₅ of the small holes of the exhaust holes of each layer 101 located on the upper sidewall of the process tube 1 is larger than the size *d*₆ of the small holes of the exhaust holes of each layer 101 located on the lower sidewall of the process tube 1. In the present embodiment, the purpose is also to exhaust the gas by using an exhaust method that the gas amount exhausted from the substrate of each layer is uniform, so that the exhaust amount of the substrate of each layer inside the process tube 1 is the same.

Other settings of this embodiment are the same as those of the first embodiment and will not be repeated here.

### Fourth embodiment

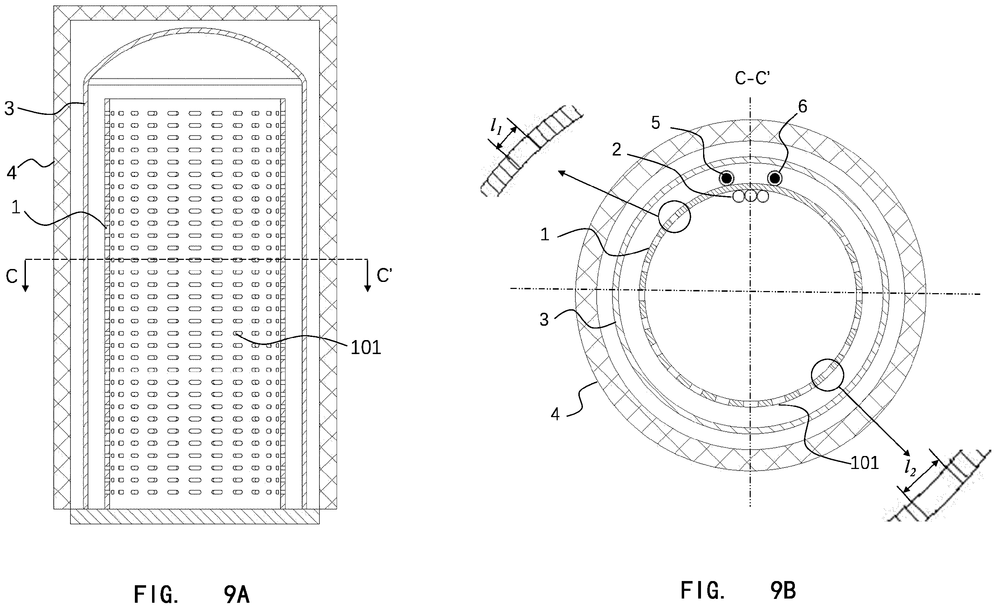

As shown in Figs. 9A and 9B, the fourth embodiment provides a furnace tube for thin film deposition, distinguished from the second embodiment or the third embodiment in that:
As shown in Fig. 9A, the exhaust holes of each layer 101 are a plurality of small holes. As shown in Fig. 9B, the exhaust holes of each layer 101 are located on a circle of the sidewall of the process tube 1.

In one embodiment, the number of the exhaust holes of each layer 101 is the same, and the size of the exhaust holes of each layer 101 gradually decreases from top to bottom along the length direction of the sidewall of the process tube 1. In another embodiment, the size of the exhaust holes of each layer 101 is the same, and the number of the exhaust holes of each layer 101 gradually decreases from top to bottom along the length direction of the sidewall of the process tube 1.

Fig. 9B is a cross-sectional view at the CC' position in Fig. 9A, in which the length of a plurality of slit holes 101 located on a circle of the sidewall of the process tube 1 gradually increases in the direction from near the gas supply holes 201 to away from the gas supply holes 201. The length *l*₁ of the slit holes 101near the gas supply holes 201 is smaller than the length *l*₂ of the slit holes 101 far away from the gas supply holes 201.

The third embodiment shown in Fig. 8 can also be used in combination with the fourth embodiment shown in Figs. 9A and 9B, that is, the size of the holes of the exhaust holes of each layer 101 is gradually reduced from top to bottom along the length direction of the sidewall of the process tube 1, and the length of a plurality of slit holes 101 located on a circle of the sidewall of the process tube 1 is gradually increased in the direction from near the gas supply holes 201 to away from the gas supply holes 201. The purpose is also to exhaust the gas by using an exhaust method that the gas amount exhausted from the substrate of each layer is uniform, so that the exhaust amount of the substrate of each layer inside the process tube 1 is the same.

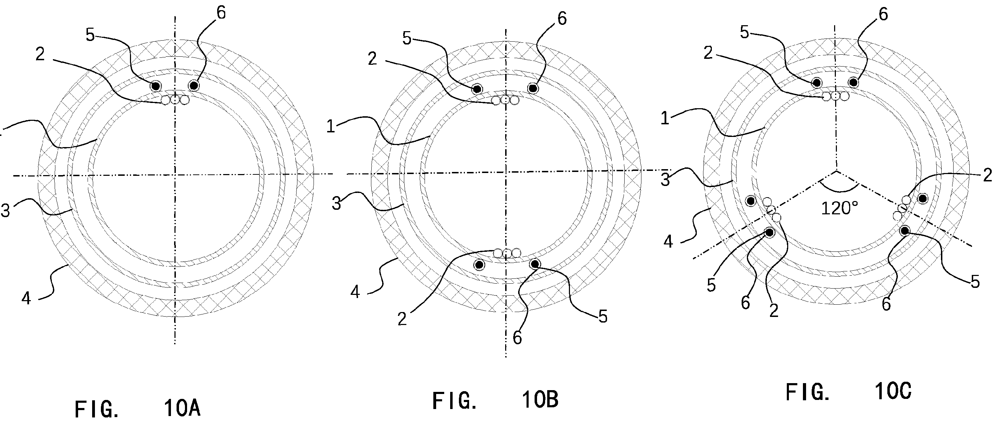

In the fourth embodiment, as shown in Figs. 10A to 10C, the furnace tube of the present invention includes several sets of gas supply tubes, and the several sets of gas supply tubes 2 is uniformly distributed along the circumference of the process tube 1. The radio-frequency electrodes 5 are provided in several sets, and several sets of radio-frequency electrodes 5 are provided in correspondence with several sets of gas supply tubes 2.

As shown in Fig. 10A, there is a set of gas supply tubes, and the radio-frequency electrodes 5 are a set; As shown in Fig. 10B, the two sets of gas supply tubes 2 are symmetrically arranged on both sides of the process tube 1, and the radio-frequency electrodes 5 are two sets corresponding to the two sets of gas supply tubes 2; As shown in Fig. 10C, the three sets of gas supply tubes 2 are uniformly distributed along the circumference of the process tube 1, and the angle formed between each adjacent two sets of gas supply tubes 2 is 120 degrees. The radio-frequency electrodes 5 are three sets, corresponding to the three sets of gas supply tubes 2.

Other settings of the embodiment are the same as those of the second embodiment or the third embodiment, and will not be repeated here.

### Fifth embodiment

The present invention also provides a method for thin film deposition based on chemical vapor deposition (CVD) using a furnace tube, which is realized based on the furnace tube provided in the first embodiment to the fourth embodiment above. Specifically, the thin film deposition method comprises the following steps:
Step 1: load a plurality of substrates onto the multi-layered supporting members of the wafer boat, and then load the wafer boat into the interior of the process tube 1, and the process gas is supplied to substrate of each layer through the gas supply tube 2 along the length direction of the process tube 1 from bottom to top by adopting a gas supply method with a uniform gas supply amount, so that the gas supply amount to substrate of each layer inside the process tube 1 is the same;
Step 2: a thin film deposition process is carried out on the surface of substrate of each layer;
Step 3: a plurality of exhaust holes 101 are provided on the sidewall of the process tube 1, and the excess process gas is exhausted through the plurality of exhaust holes 101 by an exhaust method that makes the exhaust amount of substrate of each layer uniform, so that the exhaust amount of substrate of each layer inside the process tube 1 is the same, and the excess process gas is pumped out by a gas pump.

A method for thin film deposition based on chemical vapor deposition (CVD) using the furnace tube of the present invention is illustrated below by taking the formation of silicon oxide on a substrate as an example. However, embodiments can be embodied in many different forms and should not be construed as limited to the embodiments set forth herein.
Step 10, a plurality of substrates are loaded on the multi-layered supporting members of the wafer boat, and then the wafer boat is loaded into the interior of the process tube 1. The temperature inside the process tube 1 is 700°C-800°C, and the process gas SiH₂Cl₂ with a flow rate of 0-1slm and the process gas N₂O with a flow rate of 0-1slm are supplied to the substrate of each layer from bottom to top along the length direction of the process tube 1 through the gas supply tube 2 by adopting a gas supply method with a uniform gas supply amount, so that the gas supply amount of the substrate of each layer inside the process tube 1 is the same;
Step 20: the process gas SiH₂Cl₂ and the process gas N₂O is deposited to form a thin film on the surface of substrate of each layer;
Step 30: a plurality of exhaust holes 101 are provided on the sidewall of the process tube 1, and the excess process gas SiH₂Cl₂ and the process gas N₂O are exhausted through the plurality of exhaust holes 101 by an exhaust method that makes the exhaust amount of substrate of each layer uniform, so as to make the exhaust amount of substrate of each layer inside the process tube 1 the same, and the excess process gas SiH₂Cl₂ and the process gas N₂O are pumped out by a gas pump.

### Sixth embodiment

The present invention also provides a method for thin film deposition based on chemical vapor deposition (CVD) using a furnace tube, which is realized based on the furnace tube provided in the first embodiment to the fourth embodiment above. Specifically, the thin film deposition method comprises the following steps:
Step 1: load a plurality of substrates onto the multi-layered supporting members of the wafer boat, and then load the wafer boat into the interior of the process tube 1, and the process gas is supplied to substrate of each layer through the gas supply tube 2 along the length direction of the process tube 1 from bottom to top by adopting a gas supply method with a uniform gas supply amount, so that the gas supply amount to substrate of each layer inside the process tube 1 is the same;
Step 2: the process gas is dissociated into a plasma under the action of the radio-frequency electrodes 5, and then a thin film is deposited on the surface of substrate of each layer;
Step 3: a plurality of exhaust holes 101 are provided on the sidewall of the process tube 1, and the excess process gas is exhausted through the plurality of exhaust holes 101 by an exhaust method that makes the exhaust amount of substrate of each layer uniform, so that the exhaust amount of substrate of each layer inside the process tube 1 is the same, and the excess process gas is pumped out by a gas pump.

### Seventh embodiment

The present invention also provides a method for thin film deposition based on atomic layer deposition (ALD) using a furnace tube, which is realized based on the furnace tube provided in the first embodiment to the fourth embodiment above. Specifically, the thin film deposition method comprises the following steps:
Step 1: load a plurality of substrates onto multi-layered supporting members of the wafer boat, then load the wafer boat into the interior of the process tube 1, and supply the first process gas to substrate of each layer from bottom to top through the first gas supply tube 2 along the length direction of the process tube 1 in a gas supply method with a uniform gas supply amount, so that the gas supply amount to substrate of each layer inside the process tube 1 is the same;
Step 2: the first process gas is adsorbed on the surface of substrate of each layer, multi-layered exhaust holes 101 are arranged on the sidewall of the process tube 1, and the excess first process gas is exhausted through the multi-layered exhaust holes 101, so that the exhaust amount of the substrate of each layer inside the process tube 1 is the same, and the excess first process gas is pumped out through a gas pump;
Step 3: supply purge gas through the first gas supply tube 2 to purge the interior of the process tube 1;
Step 4: supply the second process gas to substrate of each layer from bottom to top through the second gas supply tube 2 along the length direction of the process tube 1 in a gas supply method with a uniform gas supply amount, so that the gas supply amount to substrate of each layer inside the process tube 1 is the same;
Step 5: the second process gas reacts with the first process gas adsorbed on the surface of the substrate of each layer to generate a film on the surface of the substrate of each layer, and the excess second process gas is exhausted through the exhaust holes of each layer, so that the exhaust amount of the substrate of each layer is the same, and the excess second process gas is pumped out by a gas pump;
Step 6: supply purge gas through the second gas supply tube 2 to purge the interior of the process tube 1;
Step 7: repeat steps 1 to 6 above until the film deposited on the surface of substrate of each layer reaches a certain thickness.

Atomic layer deposition (ALD) process mainly involves silicon oxide, silicon nitride, metal atomic layer deposition and other processes. The method of thin film deposition based on atomic layer deposition (ALD) using the furnace tube of the present invention is illustrated below, taking silicon nitride as an example.

Step 10, a plurality of substrates are loaded on the multi-layered supporting members of the wafer boat, and then the wafer boat is loaded into the interior of the process tube 1. The temperature inside the process tube 1 is 400°C to 650°C, and the process gas Si₂Cl₆ or SiH₂Cl₂ with a flow rate of 0-3slm is supplied to the substrate of each layer from bottom to top along the length direction of the process tube 1 through the first gas supply tube 2, so that the gas supply to the substrate of each layer inside the process tube 1 is the same.
Step 20, Si₂Cl₆ or SiH₂Cl₂ is adsorbed on the surface of substrate of each layer, and a plurality of exhaust holes 101 are provided on the sidewall of the process tube 1, and the excess process gas Si₂Cl₆ or SiH₂Cl₂ is exhausted through the plurality of exhaust holes 101 by an exhaust method that uniformly exhausted from substrate of each layer, so that the exhaust amount of substrate of each layer is the same, and the excess process gas Si₂Cl₆ or SiH₂Cl₂ is pumped out by a gas pump;
Step 30, a purge gas nitrogen is supplied through the first gas supply tube 2 to purge the interior of the process tube 1 with a flow rate of 1-15slm;
Step 40, the process gas NH₃ with a flow rate of 0-5slm is supplied to substrate of each layer through the second gas supply tube 2 along the length direction of the process tube 1 from bottom to top by a gas supply method with a uniform gas supply amount, so that the gas supply amount to substrate of each layer inside the process tube 1 is the same;
Step 50, the process gas NH₃ reacts chemically with Si₂Cl₆ or SiH₂Cl₂ adsorbed on the surface of substrate of each layer to form a silicon nitride film on the surface of substrate of each layer, and the excess process gas NH₃ is exhausted through the multi-layered exhaust holes 101 by an exhaust method that uniformly exhausted from substrate of each layer, so that exhaust amount of substrate of each layer is the same, and the excess process gas NH₃ is pumped out by a gas pump;
Step 60, supply a purge gas nitrogen through the second gas supply tube 2 to purge the interior of the process tube 1, and the flow rate of the nitrogen is 1-15slm;
Step 70, repeat steps 10 to 60 above until the film deposited on the surface of substrate of each layer reaches a certain thickness.

According to the above method, when silicon oxynitride thin film is deposited based on atomic layer deposition (ALD) using the furnace tube of the present invention, the temperature inside the process tube 1 is 400°C to 650°C, the first process gas can be Si₂Cl₆ or SiH₂Cl₂ with a flow rate of 0-3slm, the second process gas can be NH₃ with a flow rate of 0-5slm, and the third process gas can be N₂O with a flow rate of 0-5slm.

According to the above method, when the furnace tube of the present invention is used for deposition of silicon oxide thin film based on atomic layer deposition (ALD), the temperature inside the process tube 1 is 200°C to 600°C, the first process gas can be Si₂Cl₆ with a flow rate of 0-3slm, and the second process gas can be H₂O with a flow rate of 0-5slm.

According to the above method, when the furnace tube of the present invention is used for alumina thin film deposition based on atomic layer deposition (ALD), the temperature inside the process tube 1 is 300°C to 600°C, the first process gas can be TiCl₄ with a flow rate of 0-1 slm, and the second process gas can be O₃ with a flow rate of 0-5 slm.

According to the above method, when titanium nitride thin film is deposited based on atomic layer deposition (ALD) using the furnace tube of the present invention, the temperature inside the process tube 1 is 300°C to 600°C, the first process gas can be TiCl₄ with a flow rate of 0-1slm, and the second process gas can be NH₃ with a flow rate of 0-5slm.

### Eighth embodiment

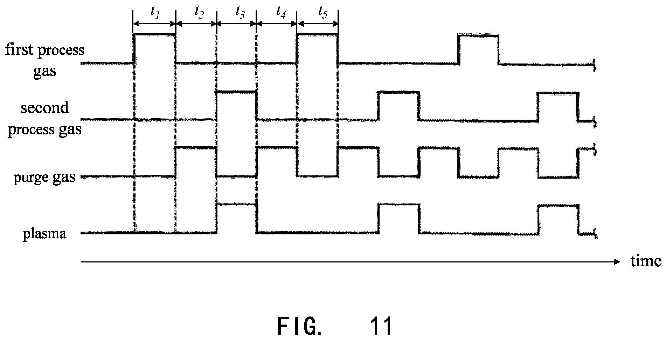

As shown in FIG. 11, the present invention also provides a method for thin film deposition based on atomic layer deposition (ALD) using furnace tubes, which is realized based on the furnace tubes provided in the first embodiment to the fourth embodiment above. Specifically, the thin film deposition method comprises the following steps: fir
Step 1: load a plurality of substrates onto the multi-layered supporting members of the wafer boat, and then load the wafer boat into the interior of the process tube 1. As shown in Fig. 11, at t₁ time, the first process gas is supplied to substrate of each layer through the first gas supply tube 2 along the length direction of the process tube 1 from bottom to top by adopting a gas supply method with uniform gas supply, so that the gas supply amount to substrate of each layer inside the process tube 1 is the same;
Step 2: the first process gas is adsorbed on the surface of substrate of each layer, a plurality of exhaust holes 101 are arranged on the sidewall of the process tube 1, and the excess first process gas is exhausted through the plurality of exhaust holes 101 by an exhaust method that makes the exhaust amount of substrate of each layer uniform, so that the exhaust amount of substrate of each layer is the same inside the process tube 1, and the excess first process gas is pumped out by a gas pump;
Step 3: as shown in Fig. 11, at t₂ time, the purge gas is supplied through the first gas supply tube 2 to purge the interior of the process tube 1;
Step 4: as shown in Fig. 11, at t₃ time, the second process gas is dissociated into a second plasma under the action of the radio-frequency electrode 5, and the second plasma is supplied to substrate of each layer from bottom to top along the length direction of the process tube 1 through the second gas supply tube 2 by a supply method with uniform supply, so that the supply to substrate of each layer inside the process tube 1 is the same;
Step 5: the second plasma reacts with the first process gas adsorbed on the surface of substrate of each layer to form a thin film on the surface of substrate of each layer, the excess second plasma is exhausted through the exhaust holes of each layer 101 by an exhaust method that makes the exhaust amount of substrate of each layer uniform, so that the exhaust amount of substrate of each layer inside the process tube 1 is the same, and the excess second plasma is pumped out by a gas pump;
Step 6: as shown in Fig. 11, at t₄ time, the purge gas is supplied through the second gas supply tube 2 to purge the interior of the process tube 1;
Step 7: repeat steps 1 to 6 above until the film deposited on the surface of substrate of each layer reaches a certain thickness.

In another embodiment, in the above-mentioned Step 1, the radio-frequency power is turned on when the first process gas is supplied. Before the first process gas is supplied to the first gas supply tube 2, it is dissociated into a first plasma under the action of the radio-frequency electrode 5. The first plasma is supplied to substrate of each layer from bottom to top along the length direction of the process tube 1 through the gas supply tube 2 by a supply method with uniform supply, so that the supply to substrate of each layer in the process tube 1 is the same.

### Ninth embodiment

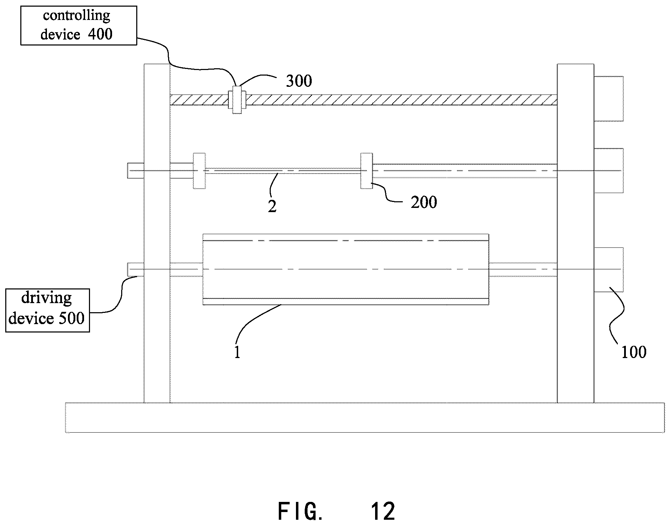

As shown in Fig. 12, the present invention also provides a processing apparatus for processing the process tube 1 and the gas supply tube 2 described above, because the perforating technology of the process tube 1 and the gas supply tube 2 described from the first to eighth embodiments is relatively complicated. The material of the process tube 1 and the gas supply tube 2 can be quartz or silicon carbide.

The processing apparatus includes: a holding device 100, a perforating device 300, a controlling device 400, and a driving device 500. The holding device 100 is used for holding a part to be processed. The perforating device 300 is provided at the top of the holding device 100 for perforating the part. The controlling device 400 is electrically connected to the perforating device 300, and the perforating device 300 is movable along the length direction of the part under the action of the controlling device 400. The controlling device 400 is configured to control the perforating position and/or the perforating size of the perforating device 300, so that the distribution area of the holes on the part is gradually reduced from top to bottom along the length direction of the sidewall of the part. The driving device 500 is connected to the holding device 100 for driving the part to rotate.

In one embodiment, the perforating device 300 can be a laser device.

In one embodiment, the holding device 100 is used to hold the process tube 1, and the process tube 1 is sleeved on the holding device 100. The processing apparatus also includes a clamping structure 200, which is detachably arranged at both ends of the holding device 100, for clamping parts to be processed with a small size. In this embodiment, the clamping structure 200 is used for clamping the gas supply tube 2.

The present invention has disclosed the relevant technology specifically and in detail through the above-described embodiments and related diagrams, so that those skilled in the art can implement it accordingly. However, the above description is intended only to explain the present invention, and should not be considered as limiting the present invention. The protection scope of the present invention should be defined by the attached claims. Any modification in the number of elements or substitution of equivalent elements described herein should still fall within the scope of the present invention.

## Claims

1. A furnace tube for thin film deposition, comprising:
a process tube;
a wafer boat, arranged inside the process tube and provided with multi-layered supporting members along the length direction of the process tube to support multi-layered substrates;
a gas supply tube, arranged inside the process tube and provided with multi-layered gas supply holes along the length direction of the process tube, the gas supply holes of each layer corresponding to the substrate of each layer one by one to supply process gas to the substrate of each layer;
multi-layered exhaust holes arranged on the sidewall of the process tube along the length direction of the sidewall of the process tube, the exhaust holes of each layer corresponding to the substrate of each layer one by one;
wherein, the distribution area of the gas supply holes on the gas supply tube is gradually reduced from top to bottom along the length direction of the sidewall of the process tube, and the distribution area of the exhaust holes on the sidewall of the process tube is gradually reduced from top to bottom along the length direction of the sidewall of the process tube, so that the gas supply amount of gas supply holes of each layer is the same, and the gas exhaust amount of exhaust holes of each layer is the same.

2. The furnace tube for thin film deposition according to claim 1, wherein the exhaust hole of each layer is a slit hole, the exhaust hole of each layer is arranged opposite the gas supply holes of each layer, the height of the slit hole of each layer is the same, and the length of the slit hole of each layer is gradually reduced from top to bottom along the length direction of the sidewall of the process tube.

3. The furnace tube for thin film deposition according to claim 1, wherein exhaust holes of each layer are multiple small holes, exhaust holes of each layer are arranged opposite the gas supply holes of each layer.

4. The furnace tube for thin film deposition according to claim 1, wherein exhaust holes of each layer are multiple slit holes, and the multiple slit holes of each layer are located on a circle of the sidewall of the process tube.

5. The furnace tube for thin film deposition according to claim 3 or 4, wherein exhaust holes of each layer are of the same size, and the number of exhaust holes of each layer decreases gradually from top to bottom along the length direction of the sidewall of the process tube.

6. The furnace tube for thin film deposition according to claim 3 or 4, wherein exhaust holes of each layer are of the same number, and the size of exhaust holes of each layer is gradually reduced from top to bottom along the length direction of the sidewall of the process tube.

7. The furnace tube for thin film deposition according to claim 4, wherein the length of multiple slit holes located on a circle of the sidewall of the process tube gradually increases in the direction from near to away from the gas supply holes.

8. The furnace tube for thin film deposition according to claim 7, wherein the size of the slit holes of each layer is gradually reduced from top to bottom along the length direction of the sidewall of the process tube.

9. The furnace tube for thin film deposition according to claim 1, comprising multiple sets of the gas supply tubes, uniformly distributed along the circumference of the process tube.

10. The furnace tube for thin film deposition according to claim 1, wherein the gas supply holes of each layer are a plurality of small holes, the gas supply holes of each layer are of the same size, and the number of gas supply holes of each layer is gradually reduced from top to bottom along the length direction of the gas supply tube.

11. The furnace tube for thin film deposition according to claim 1, wherein the gas supply holes of each layer are a plurality of small holes, the number of gas supply holes of each layer is the same, and the size of the gas supply holes of each layer is gradually reduced from top to bottom along the length direction of the gas supply tube.

12. The furnace tube for thin film deposition according to claim 1, wherein the gas supply hole of each layer is a slit hole, and the length of the gas supply hole of each layer is gradually reduced from top to bottom along the length direction of the gas supply tube.

13. The furnace tube for thin film deposition according to claim 1, wherein at least one first pumping port is arranged in the inside of the process tube.

14. The furnace tube for thin film deposition according to claim 1, wherein at least one second pumping port is arranged at the outside of the process tube.

15. The furnace tube for thin film deposition according to claim 1, wherein at least one pair of radio-frequency electrodes is arranged on the inside or outside of the process tube, and at least one pair of radio-frequency electrodes are sleeved with two insulating sleeves respectively.

16. The furnace tube for thin film deposition according to claim 1, further comprising:
a liner tube, sleeved on the outside of the process tube;
a heating assembly, sleeved on the outside of the liner tube, for heating the liner tube.

17. The furnace tube for thin film deposition according to claim 16, wherein at least one pair of radio-frequency electrodes is arranged on the outside of the liner tube.

18. A method for thin film deposition using furnace tube based on chemical vapor deposition (CVD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying process gas to the substrate of each layer from bottom to top along the length direction of the process tube through the multi-layered gas supply holes, wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the process gas is deposited to form a thin film on the surface of substrate of each layer;
Step 3: multi-layered exhaust holes are arranged on the sidewall of the process tube, and excess process gas is exhausted through the multi-layered exhaust holes, wherein the distribution area of the exhaust holes on the sidewall of the process tube is arranged to gradually decrease from top to bottom along the length direction of the sidewall of the process tube, so that the exhaust amount of substrate of each layer is the same, and the excess gas is pumped out by a gas pump.

19. A method for thin film deposition using furnace tube based on chemical vapor deposition (CVD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying process gas to the substrate of each layer from bottom to top along the length direction of the process tube through the multi-layered gas supply holes, wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the process gas is dissociated into plasma by radio-frequency electrode, and the plasma is deposited to form a thin film on the surface of substrate of each layer;
Step 3: multi-layered exhaust holes are arranged on the sidewall of the process tube, and excess process gas is exhausted through the multi-layered exhaust holes, wherein the distribution area of the exhaust holes on the sidewall of the process tube is arranged to gradually decrease from top to bottom along the length direction of the sidewall of the process tube, so that the exhaust amount of the substrate of each layer is the same, and the excess gas is pumped out by a gas pump.

20. A method for thin film deposition using furnace tube based on atomic layer deposition (ALD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying the first process gas to the substrate of each layer from bottom to top along the length direction of the process tube through the multi-layered gas supply holes, wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the first process gas is adsorbed on the surface of substrate of each layer, and multi-layered exhaust holes are arranged on the sidewall of the process tube, wherein the distribution area of the exhaust holes on the sidewall of the process tube is arranged to gradually decrease from top to bottom along the length direction of the sidewall of the process tube, and the excess first process gas is exhausted through the multi-layered exhaust holes, so that the exhaust amount of the substrate of each layer is the same, and the excess first process gas is pumped out through a gas pump;
Step 3: supplying purge gas through the gas supply tube to purge the interior of the process tube;
Step 4: the second process gas is supplied to the substrate of each layer from bottom to top along the length direction of the process tube through the multi-layered gas supply holes, so that the gas supply amount to substrate of each layer inside the process tube is the same;
Step 5: the second process gas reacts with the first process gas adsorbed on the surface of substrate of each layer to form a film on the surface of substrate of each layer, and the excess second process gas is exhausted through the exhaust holes of each layer, so that the exhaust amount of the substrate of each layer is the same, and the excess second process gas is pumped out by a gas pump;
Step 6: supplying purge gas through the gas supply tube to purge the interior of the process tube;
Step 7: repeating steps 1 to 6 above until the film deposited on the surface of substrate of each layer reaches a certain thickness.

21. A method for thin film deposition using furnace tube based on atomic layer deposition (ALD), comprising the following steps:
Step 1: loading a plurality of substrates onto multi-layered supporting members of the wafer boat, then loading the wafer boat into the interior of the process tube, setting multi-layered gas supply holes on the sidewall of the gas supply tube inside the process tube, and supplying the first process gas to the substrate of each layer from bottom to top along the length direction of the process tube through the multi-layered gas supply holes, wherein the distribution area of the gas supply holes on the gas supply tube is set to gradually decrease from top to bottom along the length direction of the sidewall of the process tube, so that the gas supply amount to substrate of each layer inside the process tube is the same;
Step 2: the first process gas is adsorbed on the surface of substrate of each layer, and multi-layered exhaust holes are arranged on the sidewall of the process tube, wherein the distribution area of the exhaust holes on the sidewall of the process tube is arranged to gradually decrease from top to bottom along the length direction of the sidewall of the process tube, and the excess first process gas is exhausted through the multi-layered exhaust holes, so that the exhaust amount of the substrate of each layer inside the process tube is the same, and the excess first process gas is pumped out through a gas pump;
Step 3: supplying purge gas through the gas supply tube to purge the interior of the process tube;
Step 4: the second process gas is dissociated into a second plasma under the action of the radio-frequency electrode, and the second plasma is supplied to the substrate of each layer from bottom to top along the length direction of the process tube through the multi-layered gas supply holes, so that the gas supply amount to substrate of each layer inside the process tube is the same;
Step 5: the second plasma reacts with the first process gas adsorbed on the surface of substrate of each layer to form a film on the surface of substrate of each layer, and the excess second plasma is exhausted through the exhaust holes of each layer, so that the exhaust amount of the substrate of each layer is the same, and the excess second plasma is pumped out by a gas pump;
Step 6: supplying purge gas through the gas supply tube to purge the interior of the process tube;
Step 7: repeating steps 1 to 6 above until the film deposited on the surface of substrate of each layer reaches a certain thickness.

22. The method for thin film deposition using furnace tube based on atomic layer deposition (ALD) according to claim 21, wherein turn on the radio-frequency power supply when the first process gas is supplied in step 1, and the first process gas is dissociated into a first plasma under the action of the radio-frequency electrode before the first process gas is supplied to the gas supply tube, and the first plasma is supplied to substrate of each layer from bottom to top along the length direction of the process tube through multi-layered gas supply holes, so that the supply amount of substrate of each layer inside the process tube is the same.

23. A processing apparatus, comprising:
a holding device, for holding a part to be processed;
a perforating device, arranged on the top of the holding device, for perforating the part;
a controlling device, electrically connected to the perforating device, wherein the perforating device is capable of moving along the length direction of the part under the action of the controlling device, wherein the controlling device is configured to make the distribution area of the holes on the part gradually decrease from top to bottom along the length direction of the sidewall of the part by controlling the perforating position and/or the perforating size of the perforating device;
a driving device, connected with the holding device, for driving the part to rotate.

24. The processing apparatus according to claim 23, further comprising a clamping structure, detachably arranged at both ends of the holding device, for clamping the part to be processed.

25. A gas supply tube of a furnace tube for thin film deposition, wherein the gas supply tube is provided with multi-layered gas supply holes along the length direction, and the distribution area of the multi-layered gas supply holes is gradually reduced from top to bottom along the length direction of the sidewall of the gas supply tube, so that when the gas is supplied from bottom to top, the gas supply amount of gas supply holes of each layer is the same.

26. A process tube of a furnace tube for thin film deposition, wherein the sidewall of the process tube is provided with multi-layered exhaust holes along the length direction, and the distribution area of the multi-layered exhaust holes is gradually reduced from top to bottom along the length direction of the sidewall of the process tube, so that the exhaust amount of exhaust holes of each layer is the same.

27. The process tube of a furnace tube for thin film deposition according to claim 26, wherein the exhaust hole of each layer is a slit hole, the slit hole of each layer has the same height, and the length of the slit hole of each layer gradually decreases from top to bottom along the length direction of the sidewall of the process tube.

28. The process tube of a furnace tube for thin film deposition according to claim 26, wherein exhaust holes of each layer are a plurality of small holes, the exhaust holes of each layer are of the same size, and the number of the exhaust holes of each layer is gradually reduced from top to bottom along the length direction of the sidewall of the process tube.

29. The process tube of a furnace tube for thin film deposition according to claim 26, wherein exhaust holes of each layer are a plurality of small holes, the number of exhaust holes of each layer is the same, and the size of exhaust holes of each layer is gradually reduced from top to bottom along the length direction of the sidewall of the process tube.

30. The process tube of a furnace tube for thin film deposition according to claim 26, wherein exhaust holes of each layer are a plurality of slit holes, and the plurality of slit holes of each layer are located on a circle of the sidewall of the process tube.

31. The process tube of a furnace tube for thin film deposition according to claim 30, wherein the size of exhaust holes of each layer is the same, and the number of exhaust holes of each layer gradually decreases from top to bottom along the length direction of the sidewall of the process tube; or the number of exhaust holes of each layer is the same, and the size of exhaust holes of each layer is gradually reduced from top to bottom along the length direction of the sidewall of the process tube.

32. The process tube of a furnace tube for thin film deposition according to claim 30, wherein the plurality of slit holes located on a circle of the sidewall of the process tube are of different sizes.

33. The process tube of a furnace tube for thin film deposition according to claim 32, wherein the size of slit holes of each layer gradually decreases from top to bottom along the length direction of the sidewall of the process tube.
